# DEMANDE DE BREVET EUROPEEN

(11) **EP 3 795 855 A1**
(43) Date de publication de la demande: **24.03.2021**
(21) Numéro de dépôt: 19198559.7
(22) Date de dépôt: 20.09.2019
(51) Int. Cl.: F16F 1/02, C30B 29/06, C30B 29/60, B81C 1/00, G04B 17/04, B81B 3/00, G04B 17/34, G04B 11/00, G04B 21/06, G04F 7/08

(54) **PROCEDE DE REALISATION D'UN RESSORT HORLOGER EN MATERIAU MONOCRISTALLIN ET RESSORT HORLOGER OBTENU PAR CE PROCEDE**

(71) Demandeur: Patek Philippe SA Genève, 1204 Genève (CH)
(72) Inventeur: BUCAILLE, Jean-Luc, 74160 Présilly (FR)
(74) Mandataire: Micheli & Cie SA

(57) **Abrégé**

L'invention propose un procédé de réalisation d'un ressort horloger (1, 2) en matériau monocristallin comprenant les étapes suivantes : dessiner le ressort (1, 2) ; identifier une ou des zones de faiblesse (4) du ressort (1, 2) par laquelle ou par au moins une desquelles le ressort (1, 2) rompra en cas de déformation excessive; fabriquer le ressort (1, 2) à partir d'une plaquette de matériau monocristallin s'étendant suivant un plan déterminé, en orientant le ressort (1, 2) dans la plaquette de telle sorte que la direction (D) des contraintes macroscopiques dans la ou chaque zone de faiblesse (4) lorsque le ressort (1, 2) est déformé soit sensiblement parallèle à un plan de clivage du matériau sécant au plan déterminé. L'invention propose aussi un ressort horloger (1, 2) obtenu par un tel procédé.

## Description

La présente invention concerne un ressort horloger en matériau monocristallin, en particulier en silicium monocristallin. Elle concerne aussi un procédé de réalisation d'un tel ressort horloger. Par le terme « ressort » on entend tout élément déformable élastiquement pour accueillir de l'énergie et/ou produire une force ou un mouvement.

Le silicium monocristallin est un matériau très apprécié dans l'horlogerie mécanique pour ses propriétés avantageuses, notamment sa faible densité, sa grande résistance à la corrosion, son caractère amagnétique et son aptitude à être usiné par des techniques de micro-fabrication. On l'utilise ainsi pour fabriquer des ressorts spiraux, des balanciers, des oscillateurs à guidage flexible, des ancres d'échappement et des roues d'échappement.

Ce matériau présente toutefois l'inconvénient d'une faible résistance mécanique. Il peut rompre facilement, sans déformation plastique préalable, sous l'effet de sollicitations externes.

Pour atténuer cet inconvénient, il est d'usage de renforcer le silicium par un revêtement d'oxyde de silicium, comme le propose la demande de brevet WO 2007/000271.

Dans le cas d'un ressort, il est important que la résistance mécanique soit la plus élevée possible car, en plus des chocs ou accélérations qu'il est susceptible de recevoir pendant son montage dans le mouvement ou lors du porter de la montre, il doit pouvoir se déformer élastiquement sans rupture pour exercer sa fonction et doit en outre pouvoir résister à la fatigue.

La présente invention vise à proposer une nouvelle approche pour augmenter la résistance mécanique d'un ressort horloger en silicium monocristallin, qui peut être combinée ou non à celle consistant à revêtir le silicium d'oxyde de silicium ou à toute autre méthode de traitement visant à améliorer la résistance mécanique.

Plus généralement, la présente invention vise à proposer une nouvelle approche pour augmenter la résistance mécanique d'un ressort horloger en matériau monocristallin.

A cette fin, il est prévu un procédé de réalisation d'un ressort horloger en matériau monocristallin comprenant les étapes suivantes :
a) dessiner le ressort,
b) identifier une ou des zones de faiblesse du ressort par laquelle ou par au moins une desquelles le ressort rompra en cas de déformation excessive,
c) fabriquer le ressort à partir d'une plaquette de matériau monocristallin s'étendant suivant un plan déterminé, en orientant le ressort dans la plaquette de telle sorte que la direction des contraintes macroscopiques dans la ou chaque zone de faiblesse lorsque le ressort est déformé soit sensiblement parallèle à un plan de clivage du matériau sécant au plan déterminé.

La présente invention propose également un ressort horloger en matériau monocristallin déformable élastiquement dans un plan déterminé et comprenant une ou des zones de faiblesse par laquelle ou par au moins une desquelles le ressort rompt en cas de déformation excessive, caractérisé en ce que la direction des contraintes macroscopiques dans la ou chaque zone de faiblesse lorsque le ressort est déformé est sensiblement parallèle à un plan de clivage du matériau sécant au plan déterminé.

La présente invention propose en outre un mouvement horloger et une pièce d'horlogerie comprenant un tel ressort.

D'autres caractéristiques et avantages de la présente invention apparaîtront à la lecture de la description détaillée suivante faite en référence aux dessins annexés dans lesquels :
- la figure 1 est une vue de dessus d'un exemple de ressort horloger pouvant être réalisé par le procédé selon l'invention, le ressort étant représenté dans un état déformé, plus précisément dans son état de déformation maximale en fonctionnement normal, et les contraintes de traction qu'il subit étant représentées par des nuances de gris ;
- la figure 2 est une vue en perspective d'une partie du ressort horloger illustré à la figure 1, avec les contraintes de traction représentées par des nuances de gris ;
- la figure 3 est un schéma montrant les différentes étapes du procédé selon l'invention ;
- la figure 4 montre schématiquement en vue de dessus (figure 4(a)) et en vue de profil (figure 4(b)) une plaquette de silicium monocristallin (100) avec un méplat [110] ;
- la figure 5 montre schématiquement en vue de dessus (figure 5(a)) et en vue de profil (figure 5(b)) une plaquette de silicium monocristallin (110) avec un méplat [100] ;
- la figure 6 montre schématiquement en vue de dessus (figure 6(a)) et en vue de profil (figure 6(b)) une plaquette de silicium monocristallin (111) avec un méplat [112].

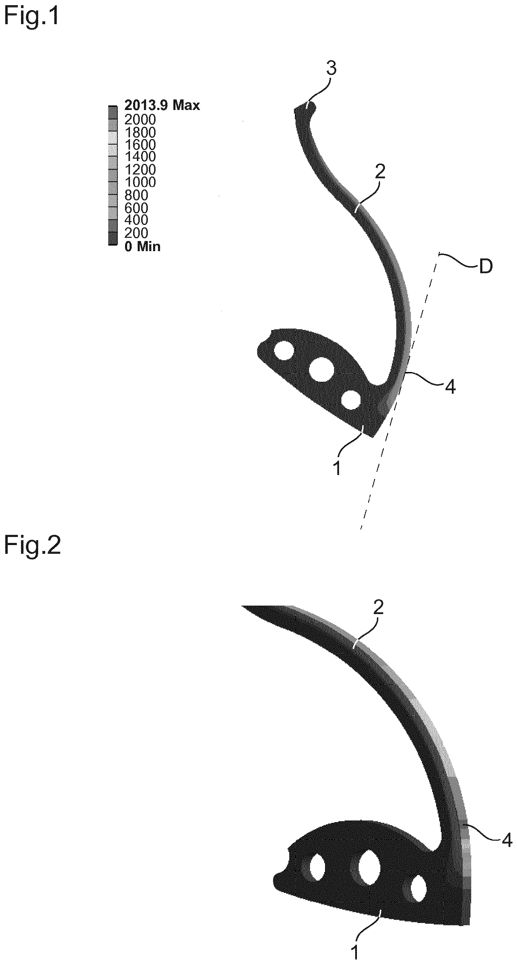

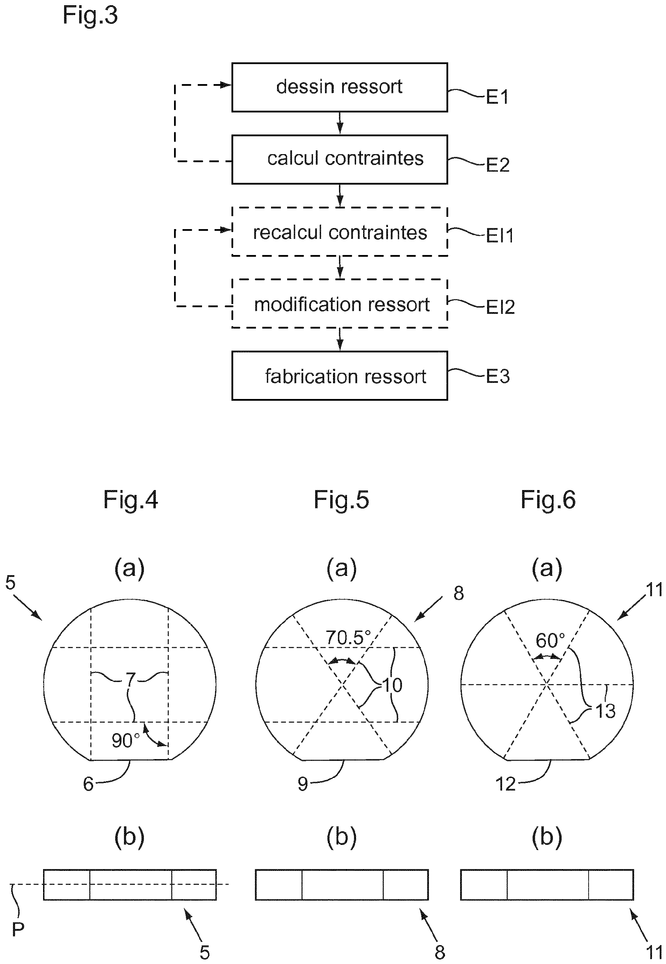

Les figures 1 et 2 montrent un ressort horloger, en l'occurrence un ressort de bascule, comprenant une base rigide 1 et un bras élastique 2. La base rigide 1 est destinée à être fixée à un bâti fixe ou mobile d'un mouvement horloger, typiquement à la platine du mouvement. Le bras élastique 2 s'étend depuis la base rigide 1 et exerce la fonction ressort. En utilisation, le bras élastique 2 travaille en flexion et agit sur la bascule par son extrémité libre 3 pour la rappeler dans une position angulaire déterminée. Pour fabriquer un tel ressort en silicium monocristallin, la présente invention propose, selon un mode de réalisation particulier, le procédé illustré à la figure 3 et décrit ci-dessous, avec ses étapes E1 à E3.

Le ressort est d'abord dessiné par conception assistée par ordinateur (étape E1) en tenant compte de la fonction qu'il est destiné à exercer et de l'emplacement qu'il est destiné à occuper dans le mouvement.

On calcule ensuite par la méthode des éléments finis (étape E2) l'intensité et la direction des contraintes macroscopiques subies par le ressort lorsqu'il est sollicité en flexion dans ses conditions d'utilisation normale. Le calcul prend en compte les dimensions du ressort et les caractéristiques élastiques (module d'élasticité et coefficient de Poisson) du matériau. Dans le cas d'un silicium monocristallin anisotrope, on peut à ce stade se baser sur un module d'élasticité et un coefficient de Poisson moyens. Le silicium étant bien moins résistant en traction qu'en compression, la simulation peut se limiter au côté du bras élastique 2 qui travaille en traction pendant la flexion, à savoir le côté droit sur la figure 1. La zone 4 du ressort où les contraintes de traction ont la plus grande intensité constitue la zone de faiblesse par laquelle le ressort rompra à partir d'une certaine force appliquée à son extrémité libre. Le calcul dans cette étape E2 peut être effectué pour l'état de déformation maximale du ressort pendant son fonctionnement normal dans le mouvement. L'expérience montre toutefois que la position de la zone de faiblesse 4 et la direction des contraintes macroscopiques dans cette zone ne varient quasiment pas avec le degré de déformation.

On fabrique ensuite le ressort par gravure, par exemple gravure ionique réactive profonde dite DRIE ou gravure laser, d'une plaquette (« wafer ») de silicium monocristallin (étape E3). La gravure est réalisée de façon que le ressort ait une orientation particulière dans la plaquette, à savoir une orientation telle que la direction D des contraintes dans la zone de faiblesse 4 soit parallèle à un plan de clivage du silicium monocristallin sécant au plan moyen P (cf. figures 4 à 6) dans lequel s'étend la plaquette et dans le lequel le ressort se déformera en utilisation.

Le silicium monocristallin possède une structure cristalline cubique de type diamant avec un atome (i) aux huit sommets du cube, (ii) au centre de chacune des faces du cube, (iii) dans quatre des huit sites tétraédriques du cube, c'est-à-dire au centre du tétraèdre formé par un coin du cube et les trois atomes au centre des trois faces adjacentes de ce coin. Les plans cristallographiques les plus denses en atomes sont des plans de clivage, autrement dit des plans de faiblesse suivant lesquels le matériau se fracture lorsqu'il est soumis à un effort trop important. Dans le cas du silicium monocristallin, les plans de clivage sont les plans de la famille {111}. La figure 4 montre une plaquette de silicium monocristallin 5 découpée dans le plan (100) avec un méplat (« wafer flat ») 6 orienté dans la direction [110]. Les pointillés 7 représentent les intersections entre le plan (100) et des plans de la famille {111}. La figure 5 montre une plaquette de silicium monocristallin 8 découpée dans le plan (110) avec un méplat 9 orienté dans la direction [100]. Les pointillés 10 représentent les intersections entre le plan (110) et des plans de la famille {111}. Enfin, la figure 6 montre une plaquette de silicium monocristallin 11 découpée dans le plan (111) avec un méplat 12 orienté dans la direction [112]. Les pointillés 13 représentent les intersections entre le plan (111) et d'autres plans de la famille {111}. Lesdites intersections 7, 10 et 13 entre le plan dans lequel est découpée la plaquette et les plans de la famille {111} constituent des directions de clivage.

Ainsi, par exemple, il est prévu à l'étape E3 du procédé selon l'invention d'orienter le ressort dans la plaquette de telle sorte que la direction D des contraintes dans la zone de faiblesse 4 soit parallèle à l'une des directions de clivage 7 si le ressort est fabriqué dans du silicium (100) avec un méplat [110], à l'une des directions de clivage 10 si le ressort est fabriqué dans du silicium (110) avec un méplat [100] et à l'une des directions de clivage 13 si le ressort est fabriqué dans du silicium (111) avec un méplat [112].

Le ressort illustré aux figures 1 et 2 comprend une seule zone de faiblesse. Avec d'autres formes de ressort, il se peut que le ressort comprenne plusieurs zones de faiblesse où les contraintes de traction sont maximales et que la direction des contraintes diffère d'une zone de faiblesse à l'autre. Si une telle configuration est constatée à l'étape E2, on oriente le ressort dans la plaquette de silicium de façon que la direction des contraintes de chaque zone de faiblesse soit parallèle à l'un des plans de clivage. Si cela n'est pas possible compte tenu des directions cristallographiques de la plaquette, on redessine le ressort (étape E1) puis on recalcule les contraintes (étape E2) jusqu'à trouver une forme du ressort comprenant une seule zone de faiblesse ou des zones de faiblesse dans lesquelles les directions respectives des contraintes peuvent être chacune parallèles à l'un des plans de clivage. Pour changer la position des zones de faiblesse et donc la direction des contraintes, on peut faire varier l'épaisseur de la lame élastique 2. Au lieu de changer la forme du ressort ou en plus de ce changement, on peut choisir une plaquette de silicium monocristallin découpée selon un autre plan cristallographique.

Entre les étapes E2 et E3 le procédé selon l'invention peut comprendre des étapes intermédiaires EI1 et EI2 consistant respectivement à recalculer les contraintes dans le ressort sur la base des caractéristiques élastiques exactes tenant compte de l'anisotropie du matériau et de l'orientation choisie pour le ressort dans la plaquette, et à modifier les dimensions et/ou la forme du ressort pour obtenir une raideur souhaitée et/ou une contrainte à la rupture souhaitée. Si la modification du ressort est de nature à changer la direction des contraintes maximales, donc le choix de l'orientation du ressort dans la plaquette, on peut mettre en œuvre ces étapes intermédiaires de manière itérative pour affiner les caractéristiques du ressort.

La résistance mécanique de ressorts horlogers réalisés selon l'invention est significativement augmentée par rapport à des ressorts dont la direction des contraintes maximales n'est parallèle à aucun plan de clivage. En particulier, des essais réalisés sur deux lots de près de trente éprouvettes chacun, les éprouvettes étant en silicium (100) recouvert d'oxyde de silicium et étant sollicitées en flexion, ont montré que la valeur médiane de la contrainte de rupture est d'environ 4,7 GPa lorsque les contraintes de la zone de faiblesse sont dirigées suivant un plan de clivage, contre environ 3,4 GPa lorsque les contraintes de la zone de faiblesse sont dirigées à 45° par rapport à un plan de clivage. Cette différence est bien supérieure à l'amélioration que peut apporter la différence de module d'élasticité entre les deux orientations de l'éprouvette. Un tel résultat est surprenant car, en sollicitant un plan de clivage comme le prévoit l'invention, on aurait pu s'attendre au contraire à diminuer la résistance mécanique. Une explication possible est que la rupture s'amorce à partir de micro-fissures dont les pointes sont soumises à des contraintes microscopiques qui n'ont pas la même direction que les contraintes macroscopiques de la zone de faiblesse.

Comme évoqué ci-dessus, les ressorts en silicium monocristallin réalisés selon l'invention peuvent être recouverts d'une couche de renfort en oxyde de silicium. L'épaisseur d'une telle couche est typiquement d'au moins 0,5 µm et par exemple comprise entre 0,5 µm et 5 µm. D'autres types de couches de renfort et/ou d'autres traitements visant à accroître encore la résistance mécanique peuvent être envisagés, comme par exemple un traitement de lissage des surfaces des ressorts.

L'amélioration de la résistance mécanique obtenue par l'invention peut servir à réduire les dimensions du ressort pour une force donnée exercée en fonctionnement courant et ainsi à diminuer son encombrement dans le mouvement horloger.

L'invention peut s'appliquer à divers types de ressort horloger, en particulier à des ressorts de bascule, des ressorts de marteau, des ressorts de levier, des sautoirs, des guidages flexibles (par exemple des lames parallèles guidant en translation ou des pivots flexibles, notamment des pivots flexibles d'oscillateur) ou des parties élastiques de composants horlogers (tels que des roues dentées ou des viroles) servant au montage de ces composants sur des organes de support tels que des axes. L'invention peut s'appliquer notamment aux bras élastiques de la virole de spiral illustrée à la figure 10B de la demande de brevet EP 2175328.

Le matériau monocristallin des ressorts réalisés selon l'invention n'est pas nécessairement du silicium. Dans des variantes de l'invention, il peut être du diamant, de l'oxyde d'aluminium (par exemple du saphir ou du rubis) ou du carbure de silicium.

Les ressorts réalisés selon l'invention peuvent être utilisés dans le mouvement d'une montre-bracelet, d'une montre de poche ou d'une pendulette, par exemple.

## Revendications

1. Procédé de réalisation d'un ressort horloger en matériau monocristallin comprenant les étapes suivantes :
a) dessiner le ressort (1, 2),
b) identifier une ou des zones de faiblesse (4) du ressort (1, 2) par laquelle ou par au moins une desquelles le ressort (1, 2) rompra en cas de déformation excessive,
c) fabriquer le ressort (1, 2) à partir d'une plaquette de matériau monocristallin (5 ; 8 ; 11) s'étendant suivant un plan déterminé (P), en orientant le ressort (1, 2) dans la plaquette (5 ; 8 ; 11) de telle sorte que la direction (D) des contraintes macroscopiques dans la ou chaque zone de faiblesse (4) lorsque le ressort (1, 2) est déformé soit sensiblement parallèle à un plan de clivage du matériau sécant au plan déterminé (P).

2. Procédé selon la revendication 1, **caractérisé en ce que** l'étape b) comprend une étape de calcul des contraintes macroscopiques subies par le ressort lorsqu'il est déformé.

3. Procédé selon la revendication 1 ou 2, **caractérisé en ce qu'**il comprend, entre les étapes b) et c), les étapes suivantes :
(i) choisir pour le ressort une orientation dans la plaquette de matériau monocristallin telle que la direction (D) des contraintes macroscopiques dans la ou chaque zone de faiblesse (4) lorsque le ressort (1, 2) est déformé soit sensiblement parallèle à un plan de clivage du matériau sécant au plan déterminé (P),
(ii) modifier le ressort sur la base de caractéristiques élastiques du matériau monocristallin tenant compte d'une anisotropie dudit matériau et du choix de l'orientation du ressort dans la plaquette.

4. Procédé selon l'une quelconque des revendications 1 à 3, **caractérisé en ce que** la ou les zones de faiblesse (4) sont situées dans une partie du ressort (1, 2) qui est sollicitée en traction lorsque le ressort (1, 2) est déformé.

5. Procédé selon l'une quelconque des revendications 1 à 4, **caractérisé en ce que** le ressort (1, 2) comprend une seule dite zone de faiblesse (4).

6. Procédé selon l'une quelconque des revendications 1 à 5, **caractérisé en ce que** le matériau monocristallin est du silicium, du diamant, de l'oxyde d'aluminium ou du carbure de silicium.

7. Procédé selon l'une quelconque des revendications 1 à 6, **caractérisé en ce que** le ressort horloger est un ressort de bascule, un ressort de marteau, un ressort de levier, un sautoir, un guidage flexible ou une partie élastique d'un composant horloger servant au montage de ce composant horloger sur un organe de support.

8. Procédé selon l'une quelconque des revendications 1 à 7, **caractérisé en ce qu'**il comprend une étape supplémentaire de traitement permettant d'augmenter la résistance mécanique du ressort, par exemple une étape de formation d'une couche de renfort sur le ressort.

9. Ressort horloger (1, 2) en matériau monocristallin déformable élastiquement dans un plan déterminé et comprenant une ou des zones de faiblesse (4) par laquelle ou par au moins une desquelles le ressort (1, 2) rompt en cas de déformation excessive, **caractérisé en ce que** la direction (D) des contraintes macroscopiques dans la ou chaque zone de faiblesse (4) lorsque le ressort (1, 2) est déformé est sensiblement parallèle à un plan de clivage du matériau sécant au plan déterminé.

10. Ressort horloger selon la revendication 9, **caractérisé en ce que** la ou les zones de faiblesse (4) sont situées dans une partie du ressort (1, 2) qui est sollicitée en traction lorsque le ressort (1, 2) est déformé.

11. Ressort horloger selon la revendication 9 ou 10, **caractérisé en ce que** le ressort (1, 2) comprend une seule dite zone de faiblesse (4).

12. Ressort horloger selon l'une quelconque des revendications 9 à 11, **caractérisé en ce que** le matériau monocristallin est du silicium, du diamant, de l'oxyde d'aluminium ou du carbure de silicium.

13. Ressort horloger selon l'une quelconque des revendications 9 à 12, **caractérisé en ce qu'**il est un ressort de bascule, un ressort de marteau, un ressort de levier, un sautoir, un guidage flexible ou une partie élastique d'un composant horloger servant au montage de ce composant horloger sur un organe de support.

14. Ressort horloger selon l'une quelconque des revendications 9 à 13, **caractérisé en ce qu'**il est recouvert d'une couche de renfort.

15. Mouvement horloger comprenant un ressort horloger (1, 2) selon l'une quelconque des revendications 9 à 14.

16. Pièce d'horlogerie, en particulier montre-bracelet ou montre de poche, comprenant un ressort horloger (1, 2) selon l'une quelconque des revendications 9 à 14 ou un mouvement horloger selon la revendication 15.
